(19) Europäisches Patentamt
European Patent Office
Office européen des brevets

(11)    **EP 3 155 661 B1**

(12)    **FASCICULE DE BREVET EUROPEEN**

(45) Date de publication et mention
de la délivrance du brevet:
**31.07.2019  Bulletin 2019/31**

(51) Int Cl.:
***H01L 27/146*** *(2006.01)*

(21) Numéro de dépôt: **15728528.9**

(22) Date de dépôt: **12.06.2015**

(86) Numéro de dépôt international:
**PCT/EP2015/063122**

(87) Numéro de publication internationale:
**WO 2015/189363 (17.12.2015 Gazette 2015/50)**

(54) **PROCÉDÉ D'ACQUISITION D'IMAGES AU MOYEN D'UN CAPTEUR D'IMAGES CMOS**

VERFAHREN ZUR BILDAUFNAHME MIT EINEM CMOS-BILDSENSOR

METHOD FOR ACQUIRING IMAGES USING A CMOS IMAGE SENSOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:  **13.06.2014  FR 1455397**

(43) Date de publication de la demande:
**19.04.2017  Bulletin 2017/16**

(73) Titulaire: **New Imaging Technologies**
**91370 Verrières-le-Buisson (FR)**

(72) Inventeur: **NI, Yang**
**91120 Palaiseau (FR)**

(74) Mandataire: **Regimbeau**
**87 rue de Sèze**
**69477 Lyon Cedex 06 (FR)**

(56) Documents cités:
**EP-A1- 2 648 404      FR-A1- 2 910 713
FR-A1- 2 986 906      US-A1- 2004 188 727**

**Description**

Domaine de l'invention

La présente invention concerne d'une façon générale les capteurs d'images en technologie C-MOS.

Arrière plan de l'invention

La qualité d'image que fournit un capteur d'image C-MOS dépend de multiples paramètres dont deux sont particulièrement importants : le niveau de bruit et la plage dynamique de fonctionnement. Un faible niveau de bruit permet d'obtenir une image exploitable en faible niveau de lumière, tandis qu'une plage dynamique étendue améliore la qualité en condition diurne, notamment ensoleillée. La plage dynamique conditionne aussi la tolérance du capteur vis-à-vis de l'écart de lumière dans une même scène et de la variation soudaine de luminosité entre les images successives.

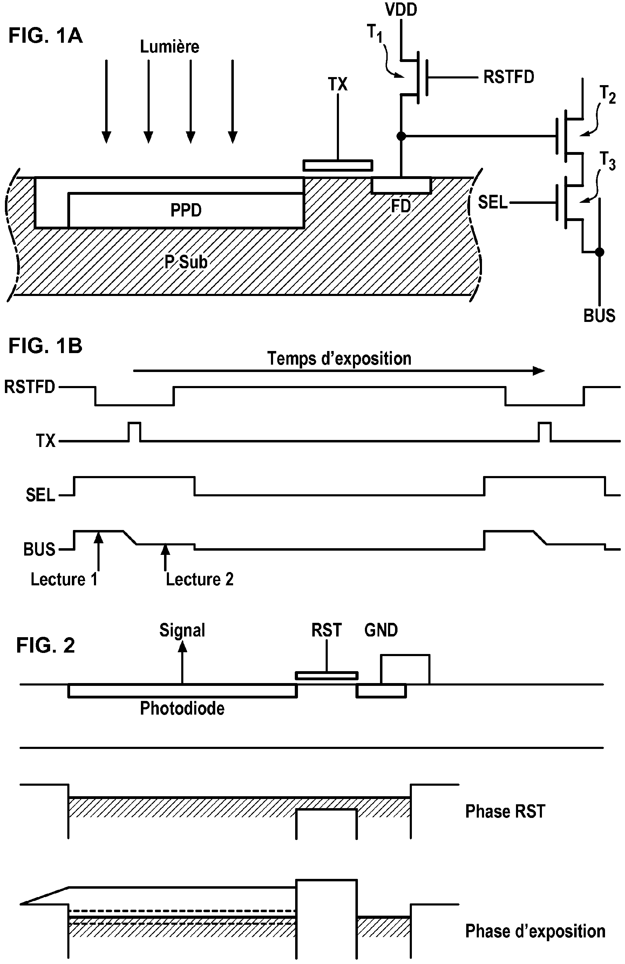

Aujourd'hui, le niveau de bruit d'un pixel CMOS à transfert de charge, souvent appelé pixel à 4 transistors ou simplement pixel de type 4T, tel qu'illustré schématiquement sur la Figure 1A, est réduit quasiment à la limite physique. Cette bonne performance est essentiellement due à l'utilisation d'une photodiode enterrée (PPD pour « Pinned Photo Diode » en terminologie anglo-saxonne), initialement complètement désertée, associée à une porte de transfert de charge vers un noeud de diffusion flottante FD. Deux lectures corrélées, réalisées avant et après le transfert de charges sur le noeud de diffusion flottante, permet une suppression quasi-totale du bruit de réinitialisation (bruit KTC proportionnel à la capacité).

Sachant que la photodiode enterrée ne contient pas de charges mobiles au début de la photo-conversion et après son transfert, elle ne contribue pas à la génération du bruit KTC. De plus, la charge photoélectrique est mesurée sur la diffusion flottante FD, dont la capacité est dissociée à celle de la photodiode. Donc la photodiode enterrée ne collecte que la charge photoélectrique, qui est ensuite mesurée sur la diffusion flottante après transfert.

Une faible capacitance de la diffusion flottante augmente sensiblement la variation de tension par chaque photoélectron transféré, et ceci améliore le rapport signal sur bruit global car le bruit du système reste relativement constant. Par exemple, pour un bruit de fond d'un système à $160\mu V$, pour une capacité de 5fF donnant une variation de tension de $32\mu V$ par électron, ce bruit système équivaut 5 électrons sur la diffusion flottante FD. Et avec une capacité de 1fF pour la diffusion flottante FD, un bruit de fond de $160\mu V$ se traduit par seulement 1 électron.

La structure de pixel à transfert de charge dispose d'une bonne sensibilité par une faible valeur de capacité de la diffusion flottante FD et un dispositif de transfert de charge efficace, mais la dynamique de fonctionnement se trouve réduite car une faible capacitance de la zone de diffusion flottante FD lui empêche d'accueillir des quantités de charges importantes. Par exemple, une capacité de la zone de diffusion flottante FD de 5fF sur 1V de variation de tension donne 31250 électrons tandis que 1fF sur 1V ne donne que 6250 électrons. Cela signifie qu'une cellule de type 4T sature très vite. Tous les efforts d'aujourd'hui sont mis sur l'augmentation de la capacité d'intégration de la PPD et de la capacité de stockage de la diffusion flottante FD.

La variation de tension générée par un électron sur une diffusion flottante FD est définie comme facteur ou gain de conversion. Par exemple, une capacité de la diffusion flottante FD de 5fF donne un facteur de conversion de $32\mu V/e$. La quantité de charges acceptée par un pixel dans sa plage de fonctionnement linéaire est ce que l'on dénomme la « Full Well Capacity » (FWC). La FWC d'un pixel de type 4T est limitée soit par la capacité de stockage de la photodiode enterrée, soit par la quantité maximale de charges acceptable par la diffusion flottante FD.

La photodiode enterrée PPD de la Figure 1A est constituée de façon connue en soi d'un dopage N dans un substrat P, le dopage N étant recouvert d'une fine couche de dopage P à très forte dose. Quand la zone N (cathode) de la photodiode enterrée est polarisée en inverse à une tension suffisamment élevée, cette zone N est complètement désertée de charges mobiles (électrons). Cette tension notée Vpin est appelée « pinning voltage » ; elle conditionne la capacité de stockage des photo-électrons par surface unitaire dans la photodiode. Ceci explique le recours à un fort dopage surfacique qui repousse la zone de désertion le plus possible dans la zone N afin d'augmenter le la valeur de la capacité FWC pour une même valeur Vpin. La tension Vpin dans une conception de pixel classique est fixée en général autour d'1V.

Si le facteur de conversion d'un tel pixel de type 4T est relativement facile à augmenter grâce à la finesse de la gravure utilisée, la valeur de la capacité FWC est plus difficile à conserver dans la course vers la résolution où la taille de chaque pixel devient de plus en plus petite. On constate simplement que la limite physique ultime de la capacité FWC est le nombre des atomes dopants dans la photodiode. Or la faible tension d'alimentation dans un pixel C-MOS conduit à un niveau de dopage relativement faible et un volume de dopage assez restreint. Il est donc difficile d'obtenir une dynamique de fonctionnement d'un pixel de type 4T au delà de 60-70 dB (facteur 1 000). Or des applications comme la vidéo surveillance, la vision automobile, etc. nécessitent une plage dynamique de l'ordre de 120 dB (facteur 1 000 000).

Différentes approches ont été imaginées pour augmenter cette dynamique, comme résumé ci-dessous.

Le document US6921934B2 propose une structure double photodiode enterrée pour augmenter la capacité de stockage de la photodiode.

Le document US6677656B2 propose une photodiode enterrée avec une couche P pour augmenter la capacité d'intégration de la photodiode.

Le document US7705900B2 propose de combiner sélectivement plusieurs diffusions flottantes afin d'augmenter la capacité de la diffusion flottante en fort niveau d'éclairement.

Le document WO2004/112376A1 propose de moduler la capacité de la diffusion flottante afin d'ajuster le facteur de conversion et la capacité de mesure de charge.

Le document WO2012/092194A1 propose une modulation de la capacité de la diffusion flottante par tension de programmation.

Le document WO2007/021626A2 propose d'ajouter sélectivement une capacité supplémentaire sur la diffusion flottante afin d'augmenter la capacité de mesure de charge.

On rappellera que le document EP1354360A1, ayant le même inventeur que la présente demande de brevet, décrit un pixel avec une photodiode en mode cellule solaire, produisant une réponse logarithmique en fonction de l'intensité lumineuse. Avec le même inventeur, Les brevets EP2186318A1 et WO2010/103464A1 apportent des améliorations en compacité et en consommation électrique. Les capteurs réalisés selon ces documents donnent une excellente dynamique de fonctionnement en ne présentant quasiment pas de saturation même en très forte illumination. La dynamique de fonctionnement dépasse largement les 120dB. Le document FR 2 986 906 divulgue une structure de pixel actif à transfert de charge amélioré.

Mais ces structures de pixel connues présentent une sensibilité qui est perfectible, et peuvent difficilement couvrir les besoins en bas niveau de lumière imposés par des applications telles que la surveillance. Les raisons de cette faible sensibilité sont doubles :

1) Une capacité de jonction importante de la photodiode, donnant un facteur de conversion faible ; toutefois, si on augmente la taille de photodiode, elle accepte plus de charges d'origine photoélectrique mais la capacité de jonction de la photodiode est augmentée quasiment dans la même proportion. L'amplitude du signal reste sans amélioration. Ce faible facteur de conversion amplifie l'impact des bruits présents dans le système.

2) La présence d'un bruit KTC lors de la réinitialisation : dans un tel pixel logarithmique, le bruit induit par l'opération de réinitialisation est lié à la valeur de la capacité de jonction de la photodiode ne peut être compensé ; par exemple, une capacité de jonction de 10fF donne un bruit KTC de 40 électrons. Donc la situation en bruit dans un tel pixel est très proche de celle d'un pixel actif classique à 3 transistors. Comparé avec un pixel 4T où le bruit de KTC est totalement supprimé, l'écart est énorme en bas niveau de lumière.

Résumé de l'invention

La présente invention est fondée sur une approche totalement opposée à l'approche traditionnelle visant à maximiser la capacité d'intégration de la photodiode enterrée afin d'augmenter ou conserver la dynamique de fonctionnement.

Elle vise ainsi à réduire au minimum la capacité d'intégration statique et d'exploiter la charge résiduelle dans une photodiode enterrée, laissée par l'équilibre entre la photo-génération des électrons et leur évaporation.

Ainsi l'invention se fonde sur un nouveau mode opératoire de fonctionnement pour un pixel à transfert de charge, basé sur un équilibre entre le phénomène de photo-génération d'électrons et un phénomène d'évaporation thermo-ionique des électrons dans un puits potentiel à très faible hauteur de barrière électrostatique.

Grâce à l'invention, le nombre d'électrons dans la photodiode code l'intensité optique sur une échelle logarithmique et non pas sur une échelle linéaire comme dans une cellule de pixel classique. Cette loi logarithmique permet d'obtenir une plage dynamique bien plus importante, pour une population d'électrons donnée, qu'une cellule classique répondant à une loi linéaire.

Ainsi l'invention permet de réaliser un pixel à transfert de charge capable de couvrir une plage dynamique de fonctionnement allant au-delà de 120 dB.

Plus spécifiquement, selon l'invention, il est proposé un procédé d'acquisition d'images au moyen d'un capteur matriciel comprenant une matrice de cellules tel que décrit dans la revendication 1.

Certains aspects préférés mais non limitatifs de ce procédé sont les suivants :

* les moyens de lecture sont aptes à effectuer une première lecture avant transfert des charges de la photodiode, et une seconde lecture après transfert desdites charges, le niveau de lumière étant obtenu par différence entre les deux lectures.
* la zone de désertion de la photodiode s'étend sur toute l'étendue de la photodiode sous une tension de polarisation comprise entre 0 et -0,1 V.

* la cellule comprend des moyens de réinitialisation de la photodiode avant exposition.

* les moyens de transfert des charges comprennent une grille en surface du substrat semi-conducteur abritant la photodiode, polarisée pour induire un transfert de charges immédiatement sous ladite grille.

* les moyens de transfert des charges comprennent des moyens d'abaissement de barrière de potentiel induit par polarisation de drain (DIBL).

* la cellule comprend un transistor capable sous une première polarisation, de lire une valeur initiale de tension sur la diffusion flottante, et sous une deuxième polarisation, de provoquer l'abaissement de la barrière de potentiel pour transférer les charges de la photodiode vers la barrière de diffusion puis, à nouveau sous la première polarisation de lire la valeur de tension sur la diffusion flottante après transfert.

* la cellule comprend un circuit de lecture de la tension sur la diffusion flottante partagé avec au moins une autre cellule.

* la cellule comprend une diode enterrée de mémorisation de charge située au voisinage de la photodiode, et des moyens pour transférer la charge dans la photodiode enterrée vers la diode enterrée de mémorisation.

Selon l'invention, le capteur matriciel comprenant en outre des moyens formant barrière à la diffusion des charges évaporées d'une cellule vers une cellule adjacente.

Certains aspects préférés mais non limitatifs de ce capteur sont les suivants :

* les moyens formant barrière comprennent des zones profondes d'ions implantés pour la recombinaison des charges, ces zones étant agencées entre les cellules.

* les moyens formant barrière comprennent des tranchées profondes creusées dans le substrat entre les cellules.

* les moyens formant barrière comprennent des zones profondes dopées en inverse du substrat et polarisées, agencées entre les cellules.

* le capteur comprend en outre des zones surfaciques avec dopage du même type que celui du substrat, autour des zones dopées profondes.

* les moyens formant barrière comprennent une jonction semi-conductrice enterrée, polarisée en inverse, agencée au-dessous des cellules.

Brève description des dessins

D'autres aspects, buts et avantages de la présente invention apparaîtront mieux à la lecture de la description détaillée suivante de formes de réalisation préférées de celle-ci, donnée à titre d'exemple non limitatif et faite en référence aux dessins annexés, sur lesquels :

La Figure 1A illustre une cellule photo-électrique à photodiode de type C-MOS à transfert de charge du type à 4 transistors, selon l'art antérieur,

La figure 1B est le chronogramme de fonctionnement de la cellule de la figure 1A,

La figure 2 illustre la façon dont un bruit KTC est engendré dans une photodiode à réinitialisation par court-circuitage,

La Figure 3 illustre une photodiode simple désertée à 0 V,

La Figure 4 illustre une photodiode désertée, avec couche de passivation superficielle,

La figure 5 illustre la localisation d'une réserve d'électrons libres d'origine photo-électrique dans une telle photodiode,

La figure 6 illustre des courbes de réponse d'une photodiode selon l'invention sous différentes tensions Vpin,

La figure 7 illustre une première forme de réalisation d'une cellule de pixel selon l'invention,

La figure 8 illustre une deuxième forme de réalisation d'une cellule de pixel selon l'invention,

La figure 9 illustre un transfert de charge par phénomène DIBL Dans une cellule selon l'invention,

La figure 10 illustre une troisième forme de réalisation d'une cellule de pixel selon l'invention mettant en oeuvre un tel transfert,

La figure 11 illustre une variante de cette troisième forme de réalisation, plus compacte,

La figure 12 illustre une quatrième forme de réalisation d'une cellule de pixel selon l'invention,

La figure 13 illustre une cinquième forme de réalisation d'une cellule de pixel selon l'invention,

La figure 14 illustre une première forme de réalisation d'une isolation entre cellules d'un capteur matriciel selon l'invention,

La figure 15 illustre une deuxième forme de réalisation de l'isolation entre cellules,

La figure 16 illustre une troisième forme de réalisation de l'isolation entre cellules,

Les Figures 17 et 18 illustrent une quatrième forme de réalisation de l'isolation entre cellules, la figure 18 étant une variante de la Figure 17, et

La Figure 19 illustre une cinquième forme de réalisation de l'isolation entre cellules.

Description détaillée de formes de réalisation préférées

On notera à titre liminaire que d'une figure à l'autre, des éléments identiques ou similaires sont désignés dans la mesure du possible par les mêmes signes de référence.

*1) Introduction*

En référence à la Figure 2, une photodiode en mode cellule solaire est initialisée par un transistor RST reliée à la masse GND, ce qui provoque un court-circuit de la photodiode. Ce court-circuitage vide la charge nette accumulée dans sa jonction PN, mais la cathode de la photodiode contient toujours des charges mobiles pendant ce court-circuitage.

Lorsque le transistor RST est ouvert, ces charges mobiles dans la photodiode, qui présentent une fluctuation du fait du mouvement thermique des électrons, occasionnent un bruit dit KTC où K est la constante de Boltzmann, T est la température absolue, et C est la capacitance totale de la photodiode, y compris la capacité d'entrée de l'amplificateur de lecture, ce bruit établissant un niveau de charge initial non nul et aléatoire dans la photodiode.

De façon classique en soi, la séquence opératoire consiste à lire la tension sur la photodiode en circuit ouvert, puis à lire la tension sur la photodiode en court-circuit, le signal d'image étant la différence entre ces deux lectures. A la fin du court-circuitage, le bruit KTC est laissé dans la photodiode.

En bas niveau de lumière, cette photodiode en mode cellule solaire fonctionne partiellement en mode d'intégration, le bruit KTC se retrouvant dans l'image suivante et dégradant la qualité d'image. En illumination plus forte (lumière diurne), le bruit KTC est absorbé par la photodiode, polarisée en direct par le courant d'origine photonique. Mais le mouvement des électrons libres dans la jonction de la photodiode produit alors un bruit thermique (bruit de Johnson), qui est du même ordre de grandeur que le bruit KTC initial.

On obtient donc une cellule de pixel qui présente un niveau de bruit constant sur une très large étendue de fonctionnement. Si le bruit de Johnson est moins critique en illumination diurne, le bruit KTC en bas niveau de lumière est très handicapant pour la performance de ce type de pixel logarithmique.

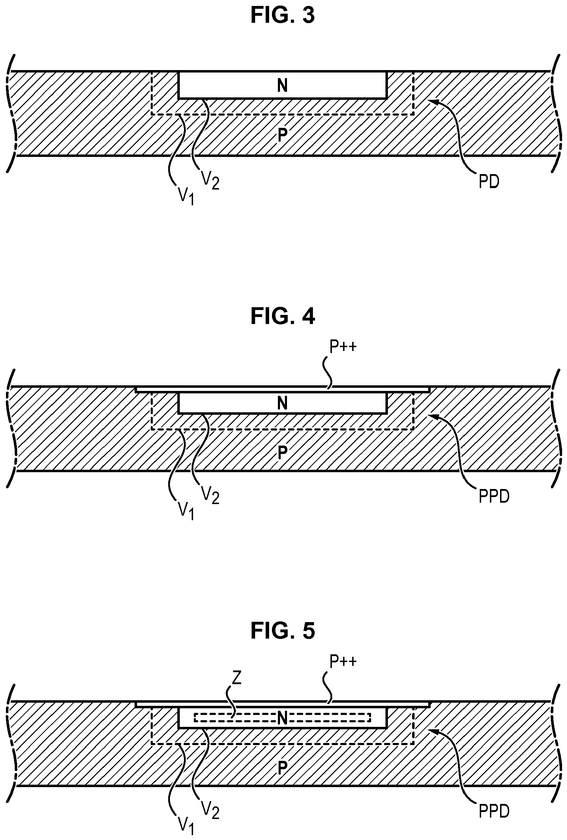

La réduction du bruit KTC ne peut être obtenue qu'en réduisant la capacité de jonction de la photodiode. Ainsi la Figure 3 illustre une photodiode avec un volume V2 de la zone N réduit par rapport à un volume conventionnel V1, et un niveau de dopage réduit, cette démarche permettant à l'extrême d'atteindre une désertion totale de la cathode pendant le court-circuitage. Quand la photodiode est complètement désertée, il n'existe donc plus de charges mobiles (il n'y a que des charges fixes laissées par les atomes donneurs) ; et aucun bruit KTC n'est engendré à la fin de la phase de court-circuitage.

Toutefois une difficulté est que, dès que la zone de désertion touche la surface du substrat, la qualité de la jonction se trouve très dégradée à cause des défauts de surface inhérents à un tel substrat.

Comme le montre la Figure 4, une couche de dopage P++ à forte dose au-dessus de la photodiode va permettre de repousser la zone de désertion vers l'intérieur de la zone dopée N. On obtient donc une photodiode enterrée de la même manière que dans un pixel à transfert de charge, à ceci près qu'elle est désertée à la tension nulle, voire légèrement négative. Mais sa capacité d'accumulation étant réduite à zéro en configuration statique, elle ne peut pas opérer dans le cadre d'un pixel de type 4T classique.

Une telle photodiode enterrée complètement désertée à zéro volt ne permet pas d'intégrer la charge d'origine photoélectrique car la barrière électrostatique ne permet pas de confiner statiquement les électrons (respectivement les trous) dans la zone N (respectivement P). C'est-à-dire que dans l'obscurité, on observe une absence de charges mobiles dans la photodiode enterrée quelle que soit la durée d'intégration, donc avantageusement un signal d'obscurité nul même avec un long temps d'exposition.

Mais sous un flux de photons, on observe l'apparition de charges mobiles dans la photodiode enterrée et, que la quantité de ces charges se stabilise devient stable au-delà d'une certaine durée d'exposition, cette stabilisation correspondant à un équilibre entre la génération photoélectrique des électrons et l'évaporation des électrons, capables de franchir la barrière potentielle peu élevée créée autour de la photodiode.

Ainsi, de préférence, la lecture sur la diffusion flottant de la tension représentative de la quantité de charges transférée est effectuée après un temps d'exposition de la photodiode suffisamment long pour atteindre cet équilibre, et donc la stabilité de la charge résiduelle.

Pour pouvoir lire la valeur de la tension liée à ces charges, il serait nécessaire, de placer un contact conducteur sur la photodiode enterrée. Mais une telle approche empêcherait toute désertion complète de la photodiode lors de son initialisation, un tel contact conducteur constituant une réserve d'électrons quasiment infinie.

La présence d'un contact étant impossible, la lecture par transfert de la charge électrique stockée dans la photodiode enterrée devient nécessaire. Il est donc prévu des moyens pour transférer la charge résiduelle vers une diffusion flottante. La quantité de charge stockée dans la photodiode n'a pas une relation linéaire comme dans un pixel à transfert de charge classique car sa capacité d'intégration statique est théoriquement nulle. C'est-à-dire que la quantité de charge n'augmente pas en fonction du temps.

En référence maintenant à la Figure 5, les charges fixes positives dans la zone de cathode attirent toujours les électrons libres présents au voisinage, générés par le phénomène photo-électrique.

Dans le même temps, ces électrons libres, localisés dans la zone Z non désertée de la cathode, ont toujours une tendance à quitter cette zone du fait de l'agitation thermique et la force de répulsion entre électrons. Quand la barrière de potentiel est suffisamment faible, tous les électrons libres quittent la cathode et la photodiode enterrée devient complètement désertée.

Ces deux phénomènes dynamiques, à savoir collecte des charges d'origine photoélectrique et déperdition des charges par évaporation, coexistent dans une photodiode enterrée désertée à 0 V.

On notera ici que dans une photodiode enterrée classique d'un pixel 4T conventionnel, l'évaporation est quasiment inexistante du fait de la hauteur de la barrière de potentiel créée par Vpin (de l'ordre 1 V contre 0 V ou légèrement négative dans le cas d'une photodiode désertée).

C'est pourquoi ce type de photodiode enterrée fonctionne donc comme un accumulateur d'électrons pur, donnant une réponse linéaire. Le phénomène d'évaporation ne se produit que quand le pixel est complètement saturé, un phénomène d'éblouissement (« blooming ») a lieu entre les pixels voisins. Dans ce cas, un pixel de type 4T perd totalement son aptitude à fournir une image exploitable.

Considérant toujours une photodiode enterrée du type N désertée à une tension Vpin de 0 V ou négative, le nombre d'électrons subsistant dans la zone de cathode peut être représentée par l'équation différentielle suivante :

$$dN = (-N_0 e^{-\frac{V_{bi}+V_{pin}+V_D}{V_T}} + G)dt, V_D = -\frac{qN}{C_{PPD}} \qquad (1)$$

où $N_0, V_{bi}, V_T, G, C_{PPD}, q$ représentent respectivement le nombre des atomes dopants, le potentiel électrochimique de la jonction, potentiel thermique d'électron, taux de génération photoélectrique, la capacité de la photodiode enterrée et la charge élémentaire.

En résolvant cette équation différentielle, on observe une relation essentiellement logarithmique entre le nombre d'électrons dans la cathode de la photodiode et l'intensité lumineuse au-delà d'un certain niveau d'éclairement.

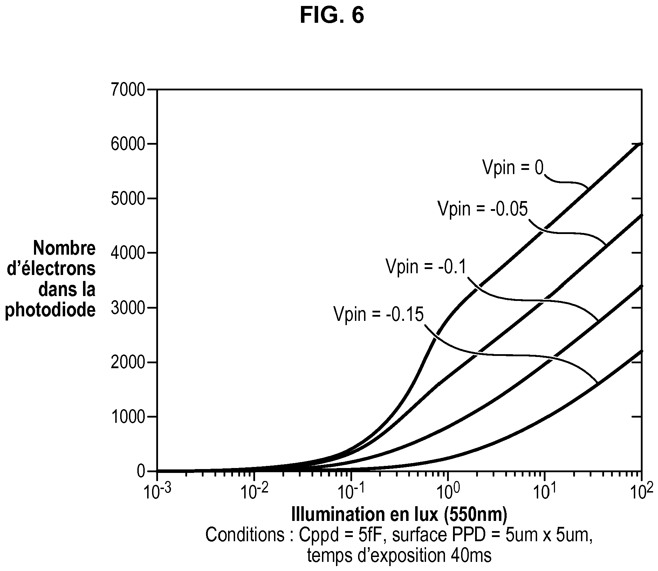

Ainsi la Figure 6 montre un ensemble de courbes exprimant la relation entre le nombre d'électrons résiduels dans la cathode et l'éclairement en Lux (en échelle exponentielle), pour différentes tensions Vpin (nulle et légèrement négatives). On observe que les courbes possèdent une partie linéaire ou quasi-linéaire importante (reflétant une réponse logarithmique compte-tenu de l'échelle exponentielle des abscisses), et que c'est pour une valeur Vpin de 0 V ou de -0,1 V que la meilleure réponse est obtenu qualitativement.

Sur un plan pratique, le choix de cette tension Vpin peut s'effectuer en calculant la probabilité qu'a un électron de s'échapper de la photodiode enterrée au bout d'un temps d'exposition souhaité. Le document « CCD Charge Injection Structure at Very Small Signal Levels », IEEE Transactions on Electron Devices, Vol. 55, No. 8 August 2008 donne les détails utiles à l'homme du métier sur le sujet.

En résumé, la présente invention est fondée sur une approche totalement opposée à l'approche traditionnelle visant à maximiser la capacité d'intégration de la photodiode enterrée afin d'augmenter ou conserver la dynamique de fonctionnement. Au contraire, on réduit ici au minimum la capacité d'intégration statique et on exploite la charge résiduelle dans la photodiode enterrée, laissée par l'équilibre entre la photo-génération des électrons et leur évaporation.

Ainsi le nombre d'électrons dans une photodiode selon la présente invention code l'intensité optique sur une échelle logarithmique et non pas sur une échelle linéaire comme dans une cellule de pixel classique. Cette loi logarithmique permet de coder le signal optique sur une plage dynamique bien plus importante, pour une population d'électrons donnée, qu'une cellule classique répondant à une loi linéaire.

Plus précisément, le maximum d'électrons disponibles étant limité par le nombre des atomes dopants, une réduction de la taille du pixel réduit en correspondance le nombre d'atomes dopants, et le fait de pouvoir coder l'intensité optique sur une échelle logarithmique étend considérablement la plage dynamique de fonctionnement. Par exemple, dans un volume de $1\mu m$ x $1\mu m$ x $0,5\mu m$ ayant un niveau de dopage de $10^{16}$ dopants/cm$^3$, le maximum des électrons libres est de 5000 et ne peut coder qu'une variation allant de 1 à 5000 (soit 74 dB). En mode logarithmique, si on suppose qu'un électron code une variation relative de 0.5% (valeur qui correspond au seuil de discrimination de l'oeil humain), 5000 électrons peuvent couvrir une plage supérieure à 200 dB.

*2) Formes de réalisation*

*a) Forme de réalisation No. 1*

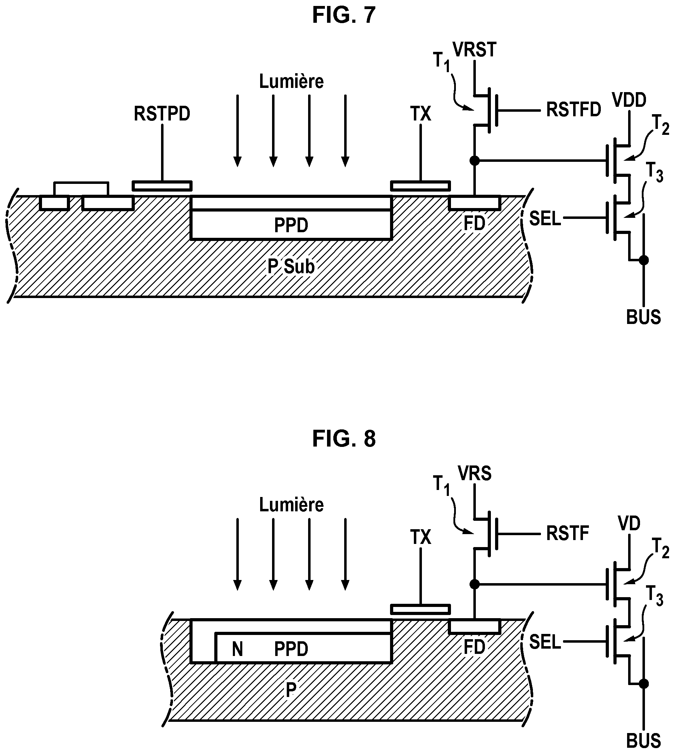

En référence tout d'abord à la Figure 7, on a représenté une cellule réalisée en technologie C-MOS qui comprend photodiode enterrée de type PPD (« Pinned Photo-Diode ») dans un substrat dopé P Sub, cette photodiode étant est remise à zéro par un transistor recevant un signal RSTPD au début de l'exposition. A la fin de l'exposition, une diffusion flottante FD est d'abord réinitialisée par un transistor T1 recevant une commande RSTFD à une tension de référence VRST. Une première lecture est faite à l'aide de la paire de transistors T2, T3 vers un bus de lecture (BUS). Un transistor de transfert TX est ensuite activé de telle sorte que la charge résiduelle de la photodiode enterrée est transférée vers la zone de diffusion flottante FD, provoquant une variation de tension sur la diffusion flottante FD. Une seconde lecture est faite à l'aide des transistors T2, T3 vers le bus de lecture BUS. La différence entre les deux lectures donne un signal d'image du pixel, exempt de bruit KTC. Cette cellule de pixel peut être placé dans une matrice en association avec des signaux de commande similaires à ceux prévus pour une matrice de pixels de type 4T conventionnels.

Pour une bonne uniformité de réponse, il faut veiller à que la hauteur des barrières de potentiel créées sous le transistor d'initialisation RSTPD et sous la grille du transistor TX soient plus élevée que le potentiel du substrat P. De la sorte, l'évaporation électronique n'aura lieu essentiellement que vers le substrat car la barrière sous le transistor TX présente toujours une forte dispersion à cause des états de surface du silicium immédiatement sous la grille.

Plus généralement, il faut éviter que l'évaporation de charge passe par la surface du semi-conducteur. A cet effet, une implantation de faible profondeur du type P en surface est avantageusement prévue pour rehausser la barrière de potentiel en surface. Cette implantation est similaire à l'implantation de champs couramment utilisée dans les processus de C-MOS standard. On notera que cette précaution est applicable à toutes les formes de réalisation de l'invention, et l'homme du métier avec ses connaissances générales saura appliquer d'autres techniques pour canaliser l'évaporation des électrons à l'intérieur du semi-conducteur.

Il est préférable que la photodiode enterrée PPD soit complètement désertée sous une tension Vpin de 0 V. Par conséquent, une tension de désertion totale légèrement négative est préférable. Dans le cas contraire, une faible charge résiduelle existerait dans la photodiode enterrée, qui engendrerait du bruit KTC et dégraderait la performance du pixel.

On notera ici que le fait de prévoir un transistor spécifiquement dédié à la réinitialisation de la photodiode enterrée permet d'assurer une meilleure uniformité de l'image dans le cas où la cellule fait partie d'un capteur matriciel.

*b) Forme de réalisation No. 2*

On comprend que dans la première forme de réalisation, le transfert des charges pendant la lecture de la photodiode enterrée vide celle-ci complètement de ses charges mobiles. Si on arrive à bien maîtriser l'uniformité de dopage dans la photodiode enterrée, le transistor de réinitialisation n'est plus nécessaire. Ainsi la Figure 8 illustre une seconde forme de réalisation où la photodiode est dépourvue de transistor de réinitialisation et où la séquence de lecture du pixel est identique à celle illustrée sur la Figure 1B.

Cette séquence commence par une réinitialisation de la zone de diffusion flottante FD. Une première lecture est ensuite faite vers le bus BUS et une seconde lecture est faite après l'action de transfert des charges réalisée par le transistor TX. Ici encore, le signal d'image est constitué par la différence entre les deux lectures. On comprend que l'exposition suivante commence directement après la fin de l'action de TX. On notera que ce mode de réalisation permet de mieux tolérer les variations de la tension Vpin, dont on rappelle qu'elle est proche de 0. Ainsi une variation positive de Vpin ne génère pas de bruit KTC car on est certain que la photodiode est complètement désertée en début d'exposition. Cette variation affecte simplement légèrement la forme de la réponse du pixel en bas niveau de lumière.

*c) Forme de réalisation No. 3*

Grâce à la finesse de gravure permise en technologie C-MOS, il est techniquement possible de réaliser deux zones de diffusion très proches l'une de l'autre dans un substrat.

Or quand deux zones de diffusion sont très proches, on observe un abaissement de barrière de potentiel quand l'une de ces diffusions est polarisée à une tension élevée. Ce phénomène connue, dénommé « Drain-Induced Barrier Lowering » en terminologie anglo-saxonne (DIBL), peut être avantageusement utilisé pour le transfert de charges entre la photodiode enterrée et la diffusion flottante FD. Dans un pixel de type 4T classique, la hauteur de la barrière potentielle de la photodiode enterrée est haute (rappelons que la hauteur de la barrière est la somme de des tensions Vpin et Vbi de la photodiode enterrée, Vbi étant le potentiel électrochimique de la jonction PN). Il est difficile d'exploiter ce phénomène pour un transfert de charge complet. Mais dans une photodiode enterrée à Vpin proche de 0V, il est possible de faire un transfert de charge complet sans utiliser une tension très élevée.

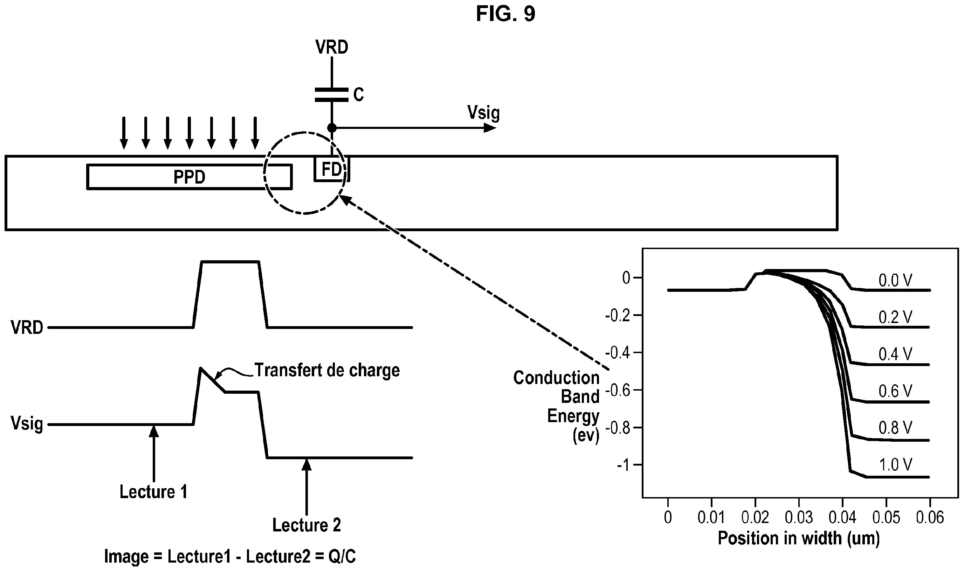

Ainsi la Figure 9 illustre un transfert de charges réalisé non plus par la polarisation d'une grille, mais par le phénomène DIBL. Une commande de lecture VRD est appliquée sur la diffusion flottante FD à travers d'un condensateur C. Lorsque le signal VRD présente la forme d'une impulsion à un niveau suffisamment haut, cette tension est transmise à la zone de diffusion flottante FD à travers le condensateur C et provoque l'abaissement de la barrière de potentiel et en conséquence le transfert des charges, une tension Vsig pouvant ensuite être lue sur la diffusion flottante FD.

Ici encore, la différence entre les deux lectures de la tension sur la diffusion flottante FD avant et après l'impulsion VRD nous donne la quantité de charges transférées.

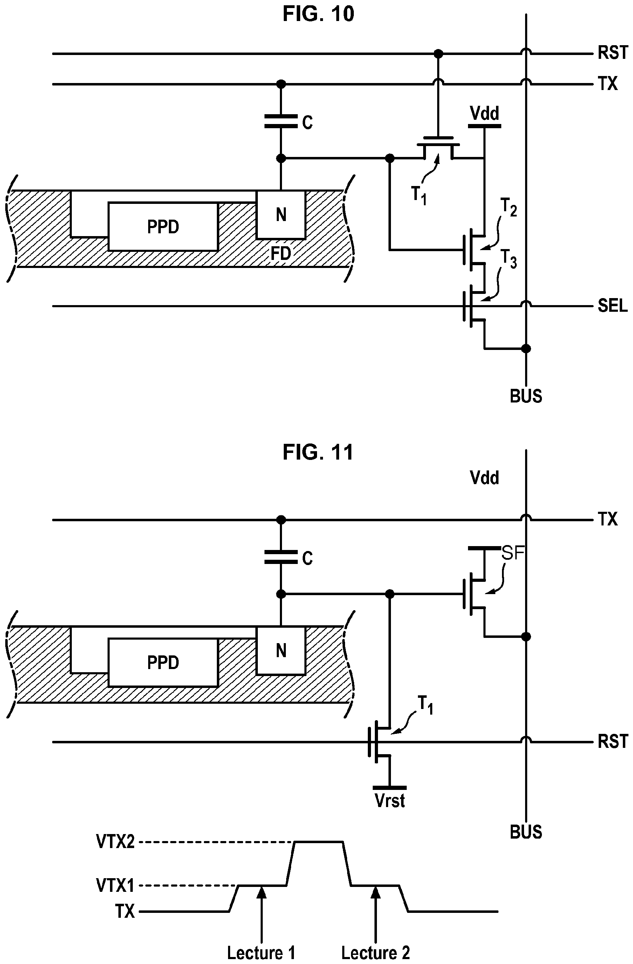

La Figure 10 illustre le schéma de principe d'une telle cellule à transfert de charge par DIBL. La zone de diffusion flottante FD est réinitialisée par un transistor T1 lui appliquant en réponse au signal RST une tension de reset élevée Vdd. Une impulsion sur le signal TX provoque ensuite l'abaissement de barrière entre la photodiode PPD et la zone de diffusion flottante FD. Les deux lectures successives vers le bus BUS sont réalisées par la commande SEL avant et après l'impulsion TX, et la différence entre ces deux lectures donne le signal d'image, à nouveau dépourvu de bruit d'origine capacitive KTC.

La Figure 11 représente un schéma de principe modifié, permettant une réalisation plus compacte en épargnant un transistor de sélection. Ainsi la zone de diffusion flottante FD est initialisée à une tension située sous le seuil du transistor du suiveur de tension SF. Le signal TX est une commande à 2 paliers. Après la réinitialisation de la diffusion flottante FD, le signal TX monte à un premier palier $V_{TX1}$ permettant de mettre le transistor suiveur SF en conduction, et une première lecture est faite sur le bus BUS. Ensuite le signal TX monte sur le second palier $V_{TX2}$, de tension plus élevée, ce qui provoque le transfert des charges par effet DIBL entre la photodiode et la diffusion flottante FD. Une seconde lecture est alors réalisée après que le signal TX est revenu sur le premier palier $V_{TX1}$. A nouveau, un signal d'image dépourvu de bruit KTC est obtenu par la différence entre les deux lectures.

On notera ici que, dans le cas où la tension de seuil du transistor SF est suffisamment faible et où le condensateur C est capable de tolérer une tension suffisamment élevée sur la ligne de commande TX, le transistor de réinitialisation T1, ainsi que sa ligne de commande, peuvent être supprimés, rendant la cellule encore plus compacte. En effet, la diffusion flottante est normalement déchargée par la lumière pendant la période d'exposition, rendant le transistor d'amplification T4 bloquant. Une valeur de $V_{TX1}$ suffisamment élevée permet alors de débloquer ce dernier pour effectuer la lecture.

*d) Forme de réalisation No. 4*

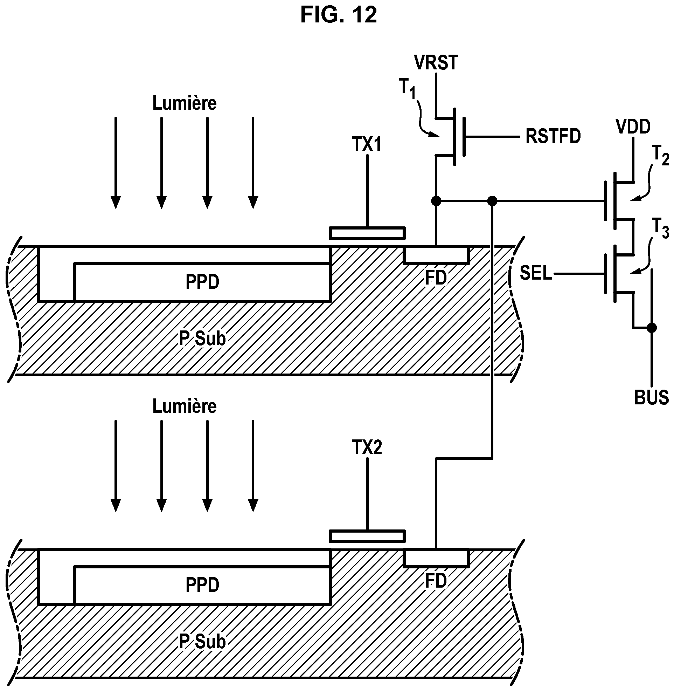

Afin de minimiser la taille d'un pixel, cette autre forme de réalisation prévoit de faire partager un suiveur de sortie par un ensemble de photodiodes correspondant à différentes cellules. La Figure 12 montre un tel agencement avec deux cellules. Les zones de diffusion FD1 et FD2 sont initialisées à chaque lecture. On lit séquentiellement les deux photodiodes PPD1 et PPD2 avec deux transistors de transfert TX1 et TX2 respectivement.

On comprend que le nombre de photodiodes ainsi lues par un suiveur de tension commun peut être augmenté.

*e) Forme de réalisation No. 5*

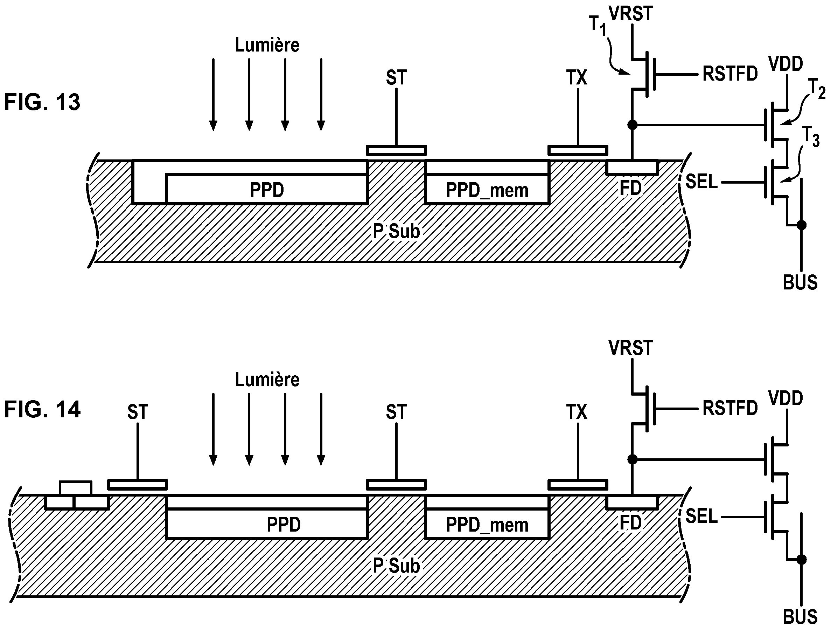

La Figure 13 illustre une réalisation d'un pixel logarithmique à transfert de charge selon l'invention, muni d'une mémoire au sein du pixel. Comme précédemment, la charge résiduelle photoélectrique de la photodiode enterrée est d'abord transférée dans une diode enterrée de mémorisation PPD_mem avant d'être lue au moyen de la grille de transfert TX et de la zone de diffusion flottante FD comme précédemment. Cette mémoire in-situ permet de réaliser un capteur d'image dit « snapshot » où les valeurs de lumière générées par les l'ensemble des photodiodes enterrées du capteur sont lues au même moment. L'image est stockée dans les diodes de mémorisation PPD_mem de toutes les cellules au même moment, avant d'être lue séquentiellement par le bus BUS. La diode de mémorisation PPD_mem peut être avantageusement réalisée en même temps que la photodiode PPD, selon le même procédé. Elle doit simplement être masquée vis-à-vis de la lumière, par exemple par une couche opaque.

La Figure 14 illustre une variante de cette forme de réalisation où l'on a complété la structure en ajoutant un transistor de réinitialisation permettant de réinitialiser toutes les photodiodes enterrées simultanément afin d'implémenter une fonction d'obturateur électronique.

*f) Amélioration de la résolution*

Dans une cellule selon l'invention, les charges mobiles évaporées à partir de la photodiode enterrée s'injectent dans le substrat. Si la densité de la matrice pixels du capteur est faible, ces charges peuvent se recombiner naturellement. Mais si la matrice de pixels est dense, alors les charges évaporées à partir d'un pixel sont susceptibles de diffuser vers les pixels voisins et de dégrader la résolution spatiale de la matrice de pixels.

Pour éviter ce phénomène, on prévoit selon un perfectionnement de l'invention des structures d'isolation entre les pixels, et l'on va décrire ci-dessous un certain nombre de configurations à cet effet, de façon non-limitative.

*i) Isolation par centres de recombinaison par implantation*

Une implantation ionique est capable de générer de nombreux défauts cristallins dans un substrat. Si un recuit est absent ou insuffisant, ces défauts persistent et deviennent des centres de recombinaison efficaces. Par ailleurs, une implantation de protons peut pénétrer profondément dans un substrat avec une énergie raisonnable (par exemple $6\mu m$ de profondeur à seulement 550KeV). Dans ce mode d'isolation, on implante des protons dans des zones neutres $IP_B$ (absence des photodiodes et des transistors) autour des pixels pour que les charges évaporées se recombinent dans ces zones.

*ii) Isolation par tranchée profonde*

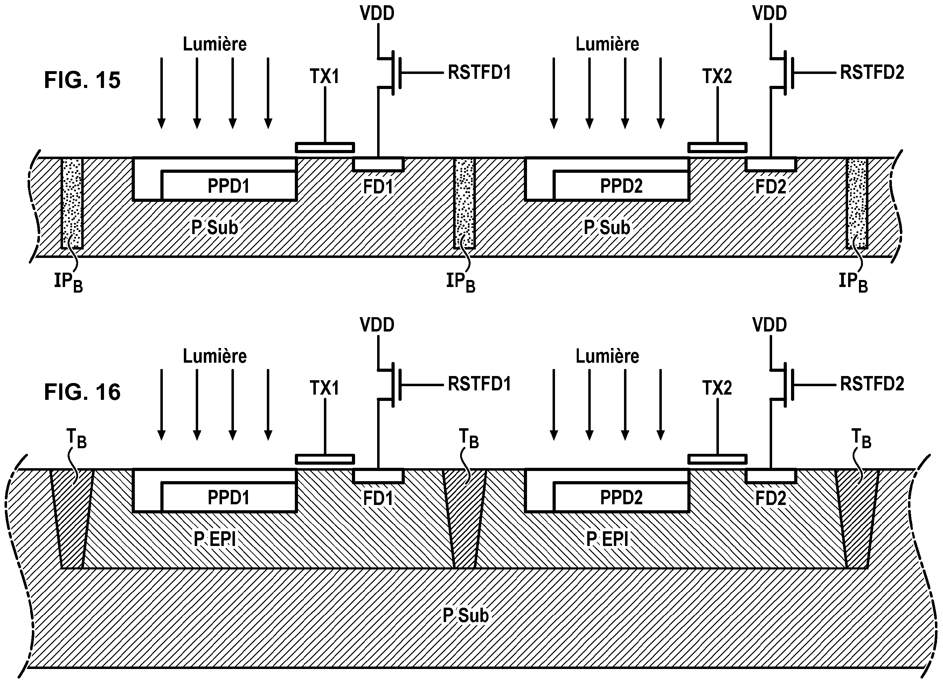

Les pixels dans une matrice peuvent aussi être entourés de tranchées profondes. En générale, une tranche épitaxiale EPI est utilisée dans la fabrication des capteurs CMOS. Un telle tranche EPI possède une fine couche épitaxiale faiblement dopée (dosage de l'ordre de $1.10^{15}$) sur un substrat fortement dopé (dosage au-delà de $1.10^{18}$). Dans le substrat fortement dopé, la durée de vie des charges mobiles est très courte du fait d'un fort taux de recombinaison. En creusant des tranchées profondes $T_B$ traversant entièrement la couche épitaxiale, une très bonne isolation entre les pixels peut être obtenue. La Figure 16 illustre une telle configuration.

*iii) Isolation par jonctions PN*

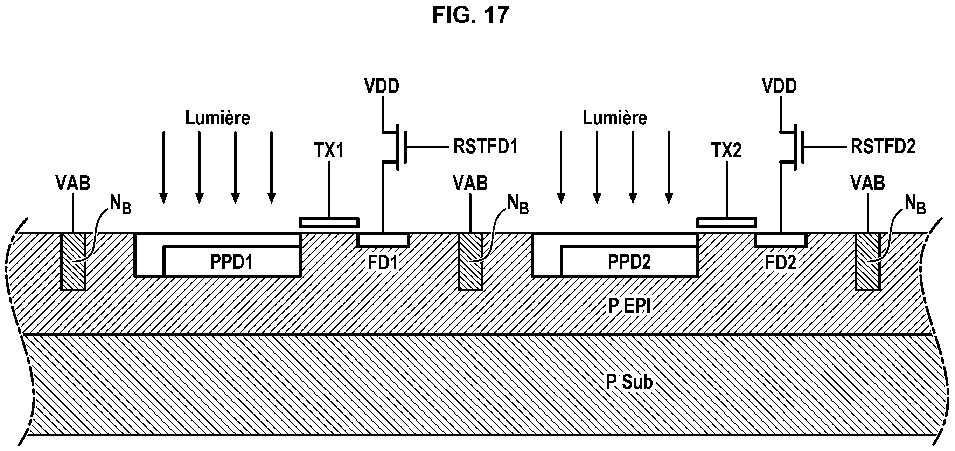

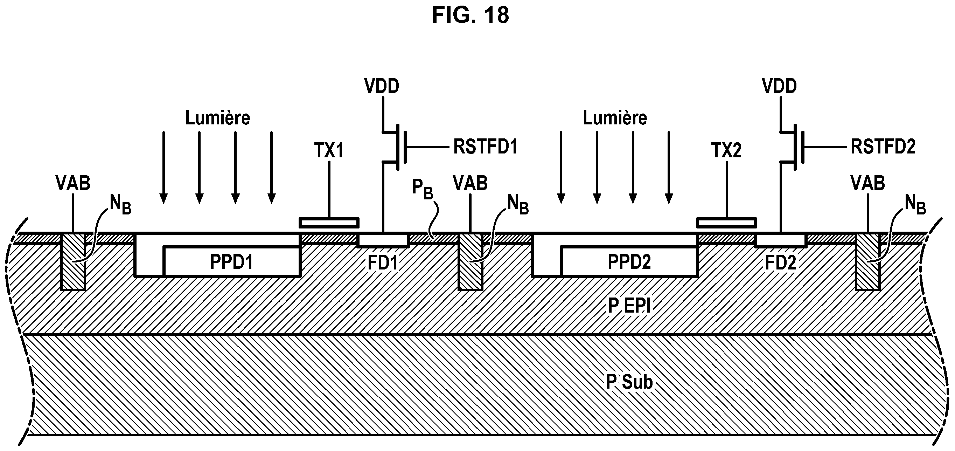

Dans une autre variante, on réalise des zones $N_B$ dopées N entre les pixels dans une matrice, pour former des zones d'absorption des électrons évaporés. Ceci est illustré sur la Figure 17. Ces zones $N_B$ sont polarisées en inverse par une tension positive VAB. On peut avantageusement utiliser la tension d'alimentation positive Vdd du pixel à cet effet. Ces zones d'absorption des électrons évaporés doivent avoir préférentiellement une profondeur au moins égale à celle de la photodiode enterrée PPD. Comme l'illustre la Figure 18, on peut avantageusement implanter sur la surface P de la couche EPI une fine couche $P_B$ de dopage P permettant d'augmenter la hauteur de la barrière électrostatique en surface, ceci afin que l'absorption des charges évaporées ait lieu principalement à l'intérieur du semi-conducteur par rapport à cette couche P. Ceci permet d'améliorer l'uniformité de l'action de la tension de polarisation inverse dans la matrice de pixels, en confinant la circulation des électrons dans la zone enterrée plutôt qu'en surface où les défauts créent des irrégularités.

*iv) Isolation par jonctions PN verticales*

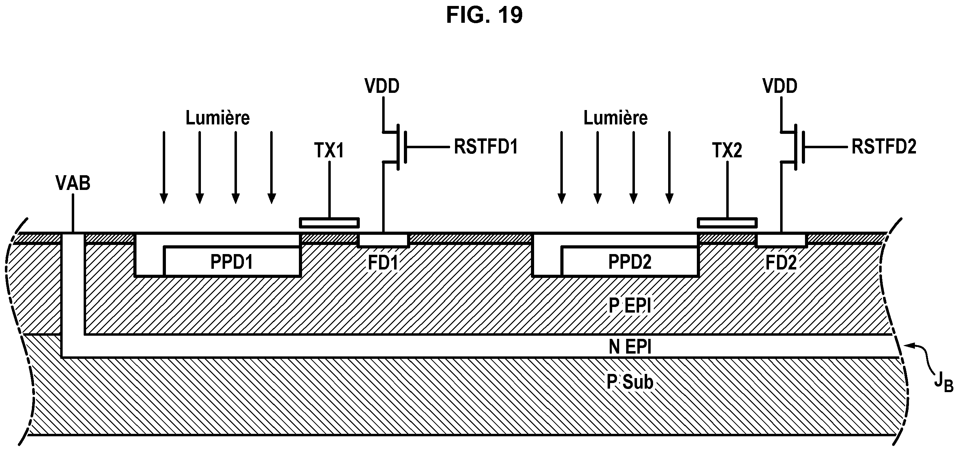

En réalisant des tranches avec une épitaxie sur mesure, il est possible de placer une couche épitaxiée N EPI sous la couche épitaxiée P EPI comme illustré sur la Figure 19. Une polarisation inverse est appliquée sur la jonction $J_B$ entre la couche P EPI et la couche N EPI. Cette structure permet d'absorber efficacement les charges évaporées sans ajouter des dispositifs supplémentaires dans les pixels. La couche N EPI peut être soit une couche d'un seul tenant sous l'ensemble de la matrice des pixels, soit un maillage sous les photodiodes enterrées de la matrice.

Bien entendu, la présente invention n'est nullement limitée aux formes de réalisation décrites et représentées, mais l'homme du métier saura y apporter de nombreuses variantes et modifications.

En particulier, bien que l'on ait décrit dans ce qui précède des modes de réalisation avec un substrat dopé P, la présente invention peut tout à fait être mise en oeuvre dans une configuration complémentaire, avec un substrat N, les charges étant alors les trous et non plus les électrons.

**Revendications**

1. Procédé d'acquisition d'images au moyen d'un capteur matriciel comprenant une matrice de cellules, la matrice de cellules comprenant une cellule photoélectrique de type C-MOS à transfert de charge, du type comprenant une photodiode enterrée (PPD) susceptible d'être exposée à des photons, formée par une zone dopée d'un premier type dans un substrat de type opposé, le procédé comprenant des étapes de transfert des charges générées par l'exposition de la photodiode aux photons vers une diffusion flottante (FD), et de lecture sur la diffusion flottante d'une tension représentative de la quantité de charges transférée, dans lequel la zone de désertion de la jonction de la photodiode (PPD) sous tension de polarisation nulle s'étend essentiellement dans toute l'épaisseur de la zone dopée de premier type, de telle sorte que la capacité de jonction de ladite photodiode et le bruit d'origine capacitive sont minimisés, dans lequel, lors de l'exposition aux photons, la quantité de charges transférée correspond à la charge résiduelle laissée dans la photodiode enterrée (PPD) par la génération de charges par photo-conversion dans la photodiode enterrée (PPD) et la perte de charges par évaporation thermo-ionique dans la photodiode enterrée, dans lequel la lecture de la tension représentative de la quantité de charges transférée est effectuée sous condition d'équilibre entre la génération de charges par photo-conversion dans la photodiode enterrée (PPD) et la perte de charges par évaporation thermo-ionique dans la photodiode enterrée (PPD),

le procédé étant **caractérisé en ce que** l'intensité optique à laquelle est exposée ladite cellule photoélectrique est codée sur une échelle logarithmique par le nombre de charges dans la charge résiduelle dans la photodiode enterrée (PPD) laissée par la génération de charges par photo-conversion dans la photodiode enterrée (PPD) et la perte de charges par évaporation thermo-ionique dans la photodiode enterrée (PPD) sous condition d'équilibre entre la génération de charges par photo-conversion dans la photodiode enterrée (PPD) et la perte de charges par évaporation thermo-ionique dans la photodiode enterrée (PPD).

**2.** Procédé selon la revendication 1, comprenant une première lecture avant transfert des charges de la photodiode, et une seconde lecture après transfert desdites charges, le niveau de lumière étant obtenu par différence entre les deux lectures.

**3.** Procédé selon l'une des revendications 1 et 2, dans lequel la zone de désertion de la photodiode (PPD) s'étend sur toute l'étendue de la photodiode sous une tension de polarisation (Vpin) comprise entre 0 et -0,1 V.

**4.** Procédé selon la revendication 1, comprenant une réinitialisation de la photodiode avant exposition.

**5.** Procédé selon l'une des revendications 1 à 4, dans lequel les charges sont transférées au moyen d'une grille (TX) en surface du substrat semi-conducteur abritant la photodiode (PPD), polarisée pour induire un transfert de charges immédiatement sous ladite grille.

**6.** Procédé selon l'une des revendications 1 à 4, comprenant un abaissement de barrière de potentiel induit par polarisation de drain (DIBL).

**7.** Procédé selon la revendication 6, comprenant une lecture, par un transistor sous une première polarisation, d'une valeur initiale de tension sur la diffusion flottante, et un abaissement, par le transistor sous une deuxième polarisation, de la barrière de potentiel pour transférer les charges de la photodiode (PPD) vers la barrière de diffusion puis, à nouveau sous la première polarisation lire la valeur de tension sur la diffusion flottante après transfert.

**8.** Procédé selon l'une des revendications 1 à 7, dans lequel la cellule comprend un circuit de lecture de la tension sur la diffusion flottante partagé avec au moins une autre cellule.

**9.** Procédé selon la revendication 1 ou 4, dans lequel la cellule comprend une diode enterrée (PPD_mem) de mémorisation de charge située au voisinage de la photodiode, et des moyens (ST) pour transférer la charge dans la photodiode enterrée vers la diode enterrée de mémorisation.

**10.** Procédé selon l'une des revendications 1 à 9, dans lequel le capteur matriciel comprend des moyens formant une barrière à la diffusion des charges évaporées d'une cellule vers une cellule adjacente.

**11.** Procédé selon la revendication 10, dans lequel les moyens formant la barrière comprennent des zones profondes d'ions implantés pour la recombinaison des charges, ces zones étant agencées entre les cellules.

**12.** Procédé selon la revendication 10, dans lequel les moyens formant la barrière comprennent des tranchées profondes creusées dans le substrat entre les cellules.

**13.** Procédé selon la revendication 10, dans lequel les moyens formant la barrière comprennent des zones profondes dopées en inverse du dopage du substrat et polarisées, agencées entre les cellules.

**14.** Procédé selon la revendication 13, dans lequel le capteur matriciel comprend en outre des zones surfaciques avec un dopage du même type que celui du substrat, autour des zones dopées profondes.

**15.** Procédé selon la revendication 10, **caractérisé en ce que** les moyens formant la barrière comprennent une jonction semi-conductrice enterrée, polarisée en inverse, agencée au-dessous des cellules.

**Patentansprüche**

**1.** Verfahren zur Aufnahme von Bildern mittels eines Matrixsensors, der eine Zellenmatrix umfasst, wobei die Zellenmatrix eine Photozelle vom C-MOS-Typ mit Ladungstransfer von dem Typ umfasst, der eine vergrabene Photodiode (PPD) umfasst, die Photonen ausgesetzt werden kann, die von einer dotierte Zone eines ersten Typs in einem Substrat von entgegengesetztem Typ gebildet wird, wobei das Verfahren Schritte des Transfers der durch das Aussetzen der Photodiode gegenüber Photonen erzeugten Ladungen zu einer schwebenden Diffusion (FD), und des Auslesens, an der schwebenden Diffusion, einer Spannung umfasst, die für die transferierte Ladungsmenge repräsentativ ist,

wobei sich die Verarmungszone des Übergangs der Photodiode (PPD) unter null Polarisationsspannung im Wesentlichen in der gesamten Dicke der dotierten Zone des ersten Typs erstreckt, derart, dass die Übergangskapazität der Photodiode und das Rauschen kapazitiven Ursprungs minimiert werden,

wobei beim Aussetzen gegenüber den Photonen die transferierte Ladungsmenge der von der Ladungserzeugung durch Photoumwandlung in der vergrabenen Photodiode (PPD) und dem Ladungsverlust durch thermoionische Verdampfung in der vergrabenen Photodiode in der vergrabenen Photodiode (PPD) zugrückgelassenen Restladung entspricht,

wobei das Auslesen der Spannung, die für die transferierte Ladungsmenge repräsentativ ist, unter Gleichgewichtsbedingung zwischen der Ladungserzeugung durch Photoumwandlung in der vergrabenen Photodiode (PPD) und dem Ladungsverlust durch thermoionische Verdampfung in der vergrabenen Photodiode (PPD) erfolgt,

wobei das Verfahren **dadurch gekennzeichnet ist, dass** die optische Intensität, der die Photozelle ausgesetzt ist, auf einer logarithmischen Skala über die Ladungsanzahl in der Restladung in der vergrabenen Photodiode (PPD), die von der Ladungserzeugung durch Photoumwandlung in der vergrabenen Photodiode (PPD) und dem Ladungsverlust durch thermoionische Verdampfung in der vergrabenen Photodiode (PPD) unter Gleichgewichtsbedingung zwischen der Ladungserzeugung durch Photoumwandlung in der vergrabenen Photodiode (PPD) und dem Ladungsverlust durch thermoionische Verdampfung in der vergrabenen Photodiode (PPD) zurücklassen wird, codiert wird.

2. Verfahren nach Anspruch 1, das ein erstes Auslesen vor Transfer der Ladungen der Photodiode, und ein zweites Auslesen nach Transfer der Ladungen umfasst, wobei der Lichtpegel über Differenz zwischen den zwei Auslesungen erhalten wird.

3. Verfahren nach einem der Ansprüche 1 und 2, wobei sich die Verarmungszone der Photodiode (PPD) über die gesamte Ausdehnung der Photodiode unter einer Polarisationsspannung (Vpin) im Bereich zwischen 0 und -0,1 V erstreckt.

4. Verfahren nach Anspruch 1, das eine Rücksetzung der Photodiode vor Aussetzung umfasst.

5. Verfahren nach einem der Ansprüche 1 bis 4, wobei die Ladungen mittels eines Gates (TX) an der Oberfläche des die Photodiode (PPD) beherbergenden Halbleitersubstrats transferiert werden, das polarisiert ist, um einen Ladungstransfer unmittelbar unter dem Gate zu erzeugen.

6. Verfahren nach einem der Ansprüche 1 bis 4, das eine durch Drain-Polarisation induzierte Potenzialbarrieren-Absenkung (DIBL) umfasst.

7. Verfahren nach Anspruch 6, das ein Auslesen, durch einen Transistor unter einer ersten Polarisation, eines ursprünglichen Spannungswerts an der schwebenden Diffusion, und ein Absenken, durch den Transistor unter einer zweiten Polarisation, der Potentialbarriere umfasst, um die Ladungen von der Photodiode (PPD) zur Diffusionsbarriere zu transferieren und anschließend erneut unter der ersten Polarisation den Spannungswert an der schwebenden Diffusion nach Transfer auszulesen.

8. Verfahren nach einem der Ansprüche 1 bis 7, wobei die Zelle eine Schaltung zum Auslesen der Spannung an der schwebenden Diffusion umfasst, die mit mindestens einer anderen Zelle geteilt wird.

9. Verfahren nach Anspruch 1 oder 4, wobei die Zelle eine vergrabene Ladungsspeicherdiode (PPD_mem), die sich in der Nähe der Photodiode befindet, und Mittel (ST) zum Transferieren der Ladung in der vergrabenen Photodiode zur vergrabene Speicherdiode umfasst.

10. Verfahren nach einem der Ansprüche 1 bis 9, wobei der Matrixsensor Mittel umfasst, die eine Barriere für die Diffusion der verdampften Ladungen von einer Zelle zu einer benachbarten Zelle bilden.

11. Verfahren nach Anspruch 10, wobei die Mittel, die die Barriere bilden, tiefe Zonen mit implantierten Ionen für die Rekombination der Ladungen umfassen, wobei diese Zonen zwischen den Zellen angeordnet sind.

**12.** Verfahren nach Anspruch 10, wobei die Mittel, die die Barriere bilden, tiefe Gräben umfassen, die zwischen den Zellen im Substrat eingesenkt sind.

**13.** Verfahren nach Anspruch 10, wobei die Mittel, die die Barriere bilden, zwischen den Zellen angeordnete tiefe Zonen umfassen, die zur Dotierung des Substrats entgegengesetzt dotiert und polarisiert sind.

**14.** Verfahren nach Anspruch 13, wobei der Matrixsensor weiter um die tiefen dotierten Zonen herum oberflächliche Zonen mit einer Dotierung desselben Typs wie derjenigen des Substrats umfasst.

**15.** Verfahren nach Anspruch 10, **dadurch gekennzeichnet, dass** die Mittel, die die Barriere bilden, einen vergrabenen, entgegengesetzt polarisierten Halbleiterübergang umfassen, der unterhalb der Zellen angeordnet ist.

**Claims**

**1.** A method for acquiring images by means of an array sensor comprising a cell array, the cell array comprising a photoelectric cell of the C-MOS type with charge transfer, of the type comprising a pinned photodiode (PPD) adapted to be exposed to photons, formed by a doped zone of a first type in a substrate of opposite type, the method comprising steps of transferring the charges generated by exposure of the photodiode to photons to a floating diffusion (FD), and of reading on the floating diffusion a voltage representative of the transferred quantity of charges, wherein the depletion zone of the junction of the photodiode (PPD) under zero biasing voltage extends essentially through the entire thickness of the doped zone of first type, such that the junction capacitance of said photodiode and the noise of capacitive origin are minimized,
wherein during exposure to photons, the transferred quantity of charges corresponds to the residual charge left in the pinned photodiode (PPD) by generation of charges by photo-conversion in the pinned photodiode (PPD) and the loss of charges by thermionic evaporation in the pinned photodiode,
wherein reading of the voltage representative of the transferred quantity of charges is done under condition of equilibrium between generation of charges by photo-conversion in the pinned photodiode (PPD) and the loss of charges by thermionic evaporation in the pinned photodiode (PPD),
the method being **characterized in that** the optic intensity to which said photoelectric cell is exposed is coded on a logarithmic scale by the number of charges in the residual charge in the pinned photodiode (PPD) left by generation of charges by photo-conversion in the pinned photodiode (PPD) and the loss of charges by thermionic evaporation in the pinned photodiode (PPD) under condition of equilibrium between the generation of charges by photo-conversion in the pinned photodiode (PPD) and the loss of charges by thermionic evaporation in the pinned photodiode (PPD).

**2.** The method according to claim 1, comprising a first reading before transfer of charges of the photodiode, and a second reading after transfer of said charges, the level of light being obtained by the difference between the two readings.

**3.** The method according to one of claims 1 and 2, wherein the depletion zone of the photodiode (PPD) extends over the entire extent of the photodiode under a biasing voltage (Vpin) of between 0 and -0.1 V.

**4.** The method according to claim 1, comprising a resetting of the photodiode before exposure.

**5.** The method according to one of claims 1 to 4, wherein the charges are transferred by means of a gate (TX) on the surface of the semi-conductive substrate housing the photodiode (PPD), biased to induce transfer of charges immediately under said gate.

**6.** The method according to one of claims 1 to 4, comprising a lowering of the potential barrier induced by drain biasing (DIBL).

**7.** The method according to claim 6, comprising a reading by a transistor under a first biasing, of an initial voltage value on the floating diffusion, and a lowering, by the transistor under a second biasing, of the potential barrier to transfer the charges of the photodiode (PPD) to the diffusion barrier then, again under the first biasing, to read the voltage value on the floating diffusion after transfer.

8. The method according to one of claims 1 to 7, wherein the cell comprises a reading circuit of the voltage on the floating diffusion shared with at least one other cell.

9. The method according to claim 1 or 4, wherein the cell comprises a pinned charge storage diode (PPD_mem) located near the photodiode, and means (ST) for transferring the charge in the pinned photodiode to the pinned storage diode.

10. The method according to one of claims 1 to 9, wherein the array sensor comprises means forming a barrier to diffusion of charges evaporated from one cell to an adjacent cell.

11. The method according to claim 10, wherein the means forming the barrier comprise deep zones of ions implanted for recombination of charges, these zones being arranged between the cells.

12. The method according to claim 10, wherein the means forming the barrier comprise deep trenches hollowed out in the substrate between the cells.

13. The method according to claim 10, wherein the means forming the barrier comprise deep zones inversely-doped of the doping of the substrate and biased, arranged between the cells.

14. The method according to claim 13, wherein the array sensor further comprises surface zones with a doping of the same type as that of the substrate, around the deep doped zones.

15. The method according to claim 10, **characterized in that** the means forming the barrier comprise a pinned semi-conductive junction, reverse-biased, arranged below the cells.

**FIG. 1A**

Lumière

VDD

T₁

RSTFD

T₂

TX

T₃

PPD

FD

SEL

P Sub

BUS

**FIG. 1B**

Temps d'exposition

RSTFD

TX

SEL

BUS

Lecture 1        Lecture 2

**FIG. 2**

Signal        RST        GND

Photodiode

Phase RST

Phase d'exposition

## FIG. 3

N

P

V$_1$ V$_2$

PD

## FIG. 4

P++

N

P

V$_1$ V$_2$

PPD

## FIG. 5

Z P++

N

P

V$_1$ V$_2$

PPD

## FIG. 6

Conditions : Cppd = 5fF, surface PPD = 5um x 5um,
temps d'exposition 40ms

# FIG. 7

Lumière

RSTPD

TX

T₁ VRST

RSTFD VDD

T₂

T₃

PPD

FD

SEL

P Sub

BUS

# FIG. 8

Lumière

TX

T₁ VRS

RSTF VD

T₂

T₃

N PPD

FD

SEL

P

BUS

FIG. 9

## FIG. 10

## FIG. 11

# FIG. 12

FIG. 13

FIG. 14

EP 3 155 661 B1

FIG. 15

FIG. 16

EP 3 155 661 B1

**FIG. 17**

EP 3 155 661 B1

# FIG. 18

**FIG. 19**

EP 3 155 661 B1

## RÉFÉRENCES CITÉES DANS LA DESCRIPTION

**Documents brevets cités dans la description**

- US 6921934 B2
- US 6677656 B2
- US 7705900 B2
- WO 2004112376 A1
- WO 2012092194 A1
- WO 2007021626 A2
- EP 1354360 A1
- EP 2186318 A1
- WO 2010103464 A1
- FR 2986906

**Littérature non-brevet citée dans la description**

- CCD Charge Injection Structure at Very Small Signal Levels. *IEEE Transactions on Electron Devices,* Août 2008, vol. 55 (8